# EUROPÄISCHE PATENTSCHRIFT

(11) **EP 0 500 032 B1**
(45) Veröffentlichungstag und Bekanntmachung des Hinweises auf die Patenterteilung: **23.04.1997**
(21) Anmeldenummer: 92102653.0
(22) Anmeldetag: 18.02.1992
(51) Int. Cl.: H01L 23/48, H02M 7/48

(54) **Stromrichterschaltungsanordnung und ihre Verwendung**
Converter device and its use
Dispositif convertisseur et son utilisation

(30) Priorität: 20.02.1991 DE 4105155
(43) Veröffentlichungstag der Anmeldung: 26.08.1992
(73) Patentinhaber: EXPORT-CONTOR Aussenhandelsgesellschaft mbH, D-90431 Nürnberg (DE)
(72) Erfinder: Tursky, Werner, Dr., W-8540 Schwabach (DE); Mourick, Paul Dr., W-8504 Stein (DE)

(56) Entgegenhaltungen:
- EP-A- 0 125 818
- EP-A- 0 381 849
- EP-B- 0 221 399
- DE-A- 3 132 337
- DE-A- 3 201 296
- DE-A- 3 601 375

## Beschreibung

Die Erfindung betrifft eine Stromrichterschaltungsanordnung gemäss dem Oberbegriff des Anspruchs 1, sowie Verwendungen dieser Stromrichterschaltungsanordnung.

Derartige Stromrichterschaltungsanordnungen weisen üblicherweise einen Gleichspannungskreis auf, aus welchem in Form von Impulsen einer bestimmten Impulsdauer Energie entnommen und in einen Wechselstromkreis eingespeist wird. Eine solche Stromrichterschaltungsanordnung ist bspw. in der EP-A-0 221 399 beschrieben. Bei derartigen Stromrichterschaltungsanordnungen wird der Gleichspannungskreis infolge der erwähnten, in den Wechselstromkreis eingespeisten Energie mit steilen Stromimpulsen belastet. Durch diese grossen Stromänderungen pro Zeiteinheit ergeben sich an den Induktivitäten des Gleichspannungskreises gemäss dem Induktionsgesetz Spannungsspitzen, die zu den Induktivitäten proportional sind. Um die erwähnten Spannungsspitzen relativ klein zu halten, wird in der oben zitierten EP-A-0 221 399 ausgeführt, dass durch entsprechende mehrlagige Ausbildung der Stromrichterschaltungsanordnung dort die Induktivität möglichst klein sein soll. Die durch die Induktivitäten des Gleichspannungskreises verursachten Spannungsspitzen führen dazu, dass die in der Stromrichterschaltungsanordnung verwendeten Bauelemente, d.h. die schaltbaren Bauelemente und die zugehörigen Freilaufdioden in ihrer Sperrspannung nicht nach der Nennspannung des Gleichspannungskreises bemessen werden können, sondern nach den in der Stromrichterschaltungsanordnung auftretenden Spannungsspitzen, die zur Induktivität und zur Stromänderung pro Zeiteinheit direkt proportional sind.

Aus der DE 36 01 375 Al ist ein Wechselrichter mit Induktivitäten zur Begrenzung der Stromanstieg- bzw. -abfallgeschwindigkeit bekannt. Bei diesem Wechselrichter sind zu diesem Zwecke, d.h. zur Begrenzung der Stromanstieg- bzw. -abfallgeschwindigkeit zu jedem schaltbaren Bauelement Induktivitäten in Reihe geschaltet. Je Phase liegen zwei steuerbare Schaltelemente in Reihe zwischen den Gleichspannungszuführungen. Der Verbraucher ist an die gemeinsamen Verbindungspunkte von je zwei Schaltelementen angeschlossen. Um die infolge Selbstinduktion der Induktivitäten erzeugten Spannungsüberhöhungen vom Verbraucher fernzuhalten, sind die Verbraucheranschlüsse je Phase über zwei in Sperrichtung geschaltete Ventile mit den Gleichspannungszuführungen verbunden. Zur Aufnahme der bei der Spannungsbegrenzung auftretenden Spannungen sind zusätzliche Induktivitäten zwischen den Verbraucheranschlüssen und den gemeinsamen Verbindungspunkten von je zwei steuerbaren Schaltelementen geschaltet.

In der Leistungselektronik sind Module in den folgenden Bauelement-Konfigurationen dominierend:

Halber Brückenzweig bestehend aus einem schaltbaren Bauelement und einer dazu antiparallelen Freilaufdiode mit zwei äusseren Hauptstromanschlüssen,

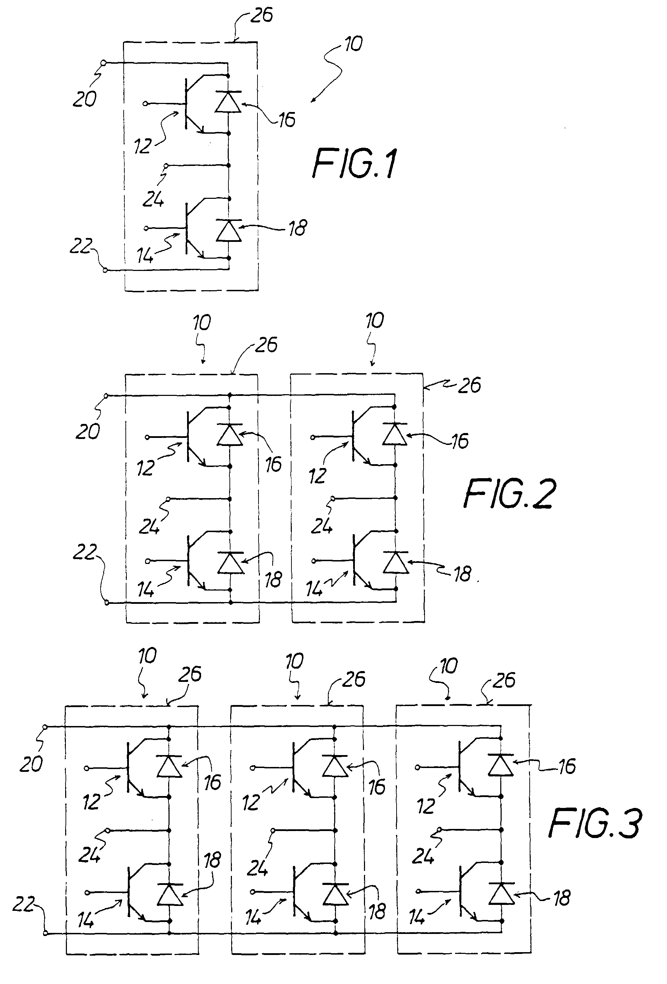

Ein Brückenzweig, wie er in Fig. 1 gezeichnet ist, mit zwei schaltbaren Bauelementen und hierzu jeweils antiparallel geschalteten Freilaufdioden mit drei äusseren Hauptstromanschlüssen in Halbbrückenschaltung,

Zwei Brückenzweige, wie sie in Fig. 2 verdeutlicht sind, mit vier schaltbaren Bauelementen und zu diesen jeweils antiparallel geschalteten Freilaufdioden und vier äusseren Hauptstromanschlüssen in Einphasen-Brückenschaltung, sowie Drei Brückenzweige, wie aus Fig. 3 ersichtlich ist, mit sechs schaltbaren Bauelementen und dazu jeweils antiparallel geschalteten Freilaufdioden und fünf äusseren Hauptstromanschlüssen in Drehstrom-Brückenschaltung.

Unter den oben erwähnten äusseren Hauptstromanschlüssen sind hierbei jene Stromanschlüsse zu verstehen, durch welche der gleichgerichtete bzw. geschaltete elektrische Strom fliesst und an welche externe Verbindungselemente zur Herstellung einer gewünschten Stromrichterschaltung anbringbar sind.

Als schaltbare Bauelemente kommen bspw. bipolare Transistoren, Feldeffekttransistoren, IGBTs oder GTOs zur Anwendung.

Nachfolgend wird die Wirkungsweise einer bekannten Stromrichterschaltungsanordnung der eingangs genannten Art mit den bei dieser Ausbildung gegebenen Mängeln beschrieben. Die folgenden Erläuterungen erfolgen am Beispiel bipolarer Transistoren für die schaltbaren Bauelemente; sie gelten jedoch bei Anwendung geeigneter anderer Bauelemente entsprechend.

Fig. 1 zeigt eine bekannte Stromrichterschaltungssanordnung 10 mit zwei in Reihe hintereinandergeschalteten schaltbaren Bauelementen 12 und 14. Zu jedem schaltbaren Bauelement 12 bzw. 14 ist eine Freilaufdiode 16 bzw. 18 antiparallel geschaltet. Mit der Bezugsziffer 20 ist ein erster Gleichspannungsanschluss, mit der Bezugsziffer 22 ein zweiter Gleichspannungsanschluss und mit der Bezugsziffer 24 ein Wechselstrom-Lastanschluss bezeichnet. Durch die die Stromrichterschaltungsanordnung 10 umgrenzende strichlierte Linie 26 soll ein Substrat angedeutet werden, auf welchem die Stromrichterschaltungsanordnung 10 vorgesehen ist. Hierbei können die schaltbaren Bauelemente 12 und 14 und die Freilaufdioden 16 und 18 jeweils als Chipbauelemente ausgebildet sein, die in bekannter Weise auf dem Substrat 26 fixiert und miteinander entsprechend Fig. 1 zusammengeschaltet sind.

Während in Fig. 1 ein Brückenzweig schaltungsmässig verdeutlicht ist, zeigt Fig. 2 zwei bekannte Brückenzweige, d.h. zwei Stromrichterschaltungsanordnungen 10 entsprechend Fig. 1, die mit ihren Gleichspannungsanschlüssen 20 und 22 parallel zusammengeschaltet sind, und die unter Ausbildung einer Einphasen-Brückenschaltung zwei Wechselstromlastanschlüsse 24 aufweisen.

Gleiche Einzelheiten sind in den Figuren 1 und 2 mit denselben Bezugsziffern bezeichnet, so dass es sich erübrigt, in Verbindung mit Fig. 2 alle diese Einzelheiten noch einmal detailliert zu beschreiben.

Fig. 3 zeigt die Ausbildung einer bekannten Drehstrom-Brückenschaltung aus drei Stromrichterschaltungsanordnungen 10 gemäss Fig. 1, die mit den Gleichspannungsanschlüssen 20 und 22 zueinander parallelgeschaltet sind, und die drei Wechselstrom-Lastanschlüsse 24 besitzt. Gleiche Einzelheiten wie in den Figuren 1 und 2 sind auch in Fig. 3 mit denselben Bezugsziffern wie in den Figuren 1 und 2 bezeichnet, so dass es sich auch bezüglich Fig. 3 erübrigt, alle diese Einzelheiten noch einmal detailliert zu beschreiben.

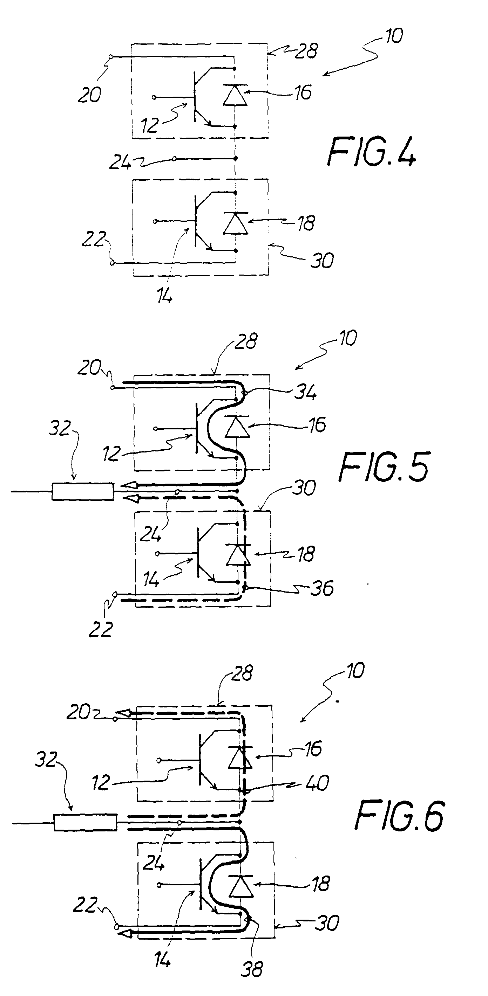

Nachfolgend wird an Hand der Figuren 4, 5 und 6 die Funktionsweise einer Stromrichterschaltungsanordnung 10 nach dem Stand der Technik entsprechend der aus der oben erwähnten DE-3601375 A1 bekannten Anordnung beschrieben, wobei sich die in den Figuren 4 bis 6 verdeutlichte Stromrichterschaltungsanordnung 10 von den Stromrichterschaltungsanordnungen 10 gemäss den Figuren 1, 2 und 3 dadurch unterscheidet, dass das schaltbare Bauelement 12 und die zu ihm antiparallel geschaltete Freilaufdiode 16 auf einem Substrat 28 und das schaltbare Bauelement 14 und die zu diesem antiparallel geschaltete Freilaufdiode 18 auf einem vom Substrat 28 getrennten, eigenen Substrat 30 vorgesehen sind. Mit der Bezugsziffer 20 ist auch in den Figuren 4 bis 6 der erste Gleichspannungsanschluss und mit der Bezugsziffer 22 der zweite Gleichspannungsanschluss bezeichnet. Mit der Bezugsziffer 24 ist in den Figuren 4 bis 6 der Wechselstrom-Lastanschluss bezeichnet. In den Figuren 5 und 6 ist ausserdem eine an den Wechselstrom-Lastanschluss 24 angeschlossene induktive oder gemischt ohmsch-induktive Last 32 angedeutet.

Aus den Figuren 4 bis 6 ist ersichtlich, dass der Abstand zwischen den Gleichspannungsanschlüssen 20 und 22 der bekannten Stromrichterschaltungsanordnung 10 relativ gross ist. Durch diese relativ grossen Abstände zwischen den Anschlüssen 20 und 22 durchfliesst der elektrische Strom in der Stromrichterschaltungsanordnung 10 beträchtliche Flächen, was bedeutet, dass die Stromführung in der Stromrichterschaltungsanordnung 10 mit beträchtlichen Induktivitäten behaftet ist, die bei schnellen Stromänderungen, d.h. beim schnellen Schalten der Bauelemente zu unerwünschten Überspannungen führen.

Mit der bekannten, in Fig. 1 oder in Fig. 4 angedeuteten Ausbildung der Stromrichterschaltungsanordnung ist ein gravierender Mangel verbunden, da -wie nachfolgend unter Bezugnahme auf die Figuren 5 und 6 ausgeführt wirdfunktionsmässig das schaltbare Bauelement 12 und die Freilaufdiode 18 sowie das schaltbare Bauelement 14 und die Freilaufdiode 16 zusammengehören. Dies wird nun an Hand der Fig. 5 erläutert. Sie stellt -wie bereits eingangs erläutert worden ist- einen Brückenzweig einer Inverterschaltung dar. Ist bspw. das schaltbare Bauelement 12 eingeschaltet, so fliesst aus dem Gleichspannungskreis, d.h. vom ersten Gleichspannungsanschluss 20 durch das schaltbare Bauelement 12 ein elektrischer Strom in die Last 32, was durch die Pfeillinie 34 angedeutet ist. Da die Last 32 induktiv oder zumindest gemischt ohmsch-induktiv ist, ändert der elektrische Strom 34 durch die Last 32 beim Ausschalten des schaltbaren Bauelementes 12 weder seine Richtung noch seine Amplitude sprungartig. Der elektrische Strom 34 fliesst vielmehr weiter in die Last 32 und zwar nun durch die Freilaufdiode 18, was durch die strichlierte Pfeillinie 36 angedeutet ist. Diesen Vorgang nennt man die Kommutierung des Laststromes vom schaltbaren Bauelement 12 auf die Freilaufdiode 18. Das schaltbare Bauelement 12 und die Freilaufdiode 18 bilden einen Kommutierungszweig.

Beim Einschalten des schaltbaren Bauelementes 12 findet der umgekehrte physikalische Vorgang statt, d.h. der elektrische Strom kommutiert von der Freilaufdiode 18 auf das schaltbare Bauelement 12.

Das schaltbare Bauelement 14 und die Freilaufdiode 16 bilden entsprechend den zweiten Kommutierungszweig der Schaltungsanordnung 10 in Form eines Brückenzweiges mit drei äusseren Anschlüssen 20, 22 und 24, der bei umgekehrtem Stromfluss durch die Last 32 entsprechend von einem elektrischen Strom durchflossen ist, der in Fig. 6 durch die Pfeillinie 38 bzw. durch die strichlierte Pfeillinie 40 angeordnet ist.

Aus diesen Pfeillinien ist ohne weiteres ersichtlich, dass die bekannte Stromrichterschaltungsanordnung 10 eine relativ grosse Induktivität besitzt, was zu entsprechend grossen unerwünschten Überspannungen führt.

Der Erfindung liegt die Aufgabe zugrunde, durch eine geeignete Ausbildung der Stromrichterschaltungsanordnung deren Induktivitäten zu minimieren und somit infolge Minimierung der zu den Induktivitäten proportionalen Überspannungen eine bessere Ausnützbarkeit der Bauelemente der Stromrichterschaltungsanordnung zu gewährleisten.

Diese Aufgabe wird bei einer Stromrichterschaltungsanordnung der eingangs genannten Art durch die Merkmale des kennzeichnenden Teiles des Anspruchs 1 gelöst. Bevorzugte Weiterbildungen der erfindungsgemässen Stromrichterschaltungsanordnung sind in den Ansprüchen 2 bis 5 gekennzeichnet und bevorzugte Verwendungen der erfindungsgemässen Stromrichterschaltungsanordnung sind in den Ansprüchen 6 bis 8 beansprucht.

Durch die erfindungsgemässe Ausbildung der Stromrichterausbildung ergibt sich nicht nur der Vorteil, dass die Induktivitäten und somit die Induktivitätsbedingten Überspannungen minimiert sind, sondern ausserdem auch der Vorteil, dass die beiden mit den zwei Gleichspannungsanschlüssen kontaktierten Stromleiter des Gleichspannungskreises nebeneinander in einem geringen Abstand verlaufen können. Durch diese Massnahmen ist die Induktivität der Kommutierungszweige insges.

vergleichsweise sehr gering, so dass die Höhe der bei der Kommutierung auftretenden Spannungsspitzen erheblich reduziert ist.

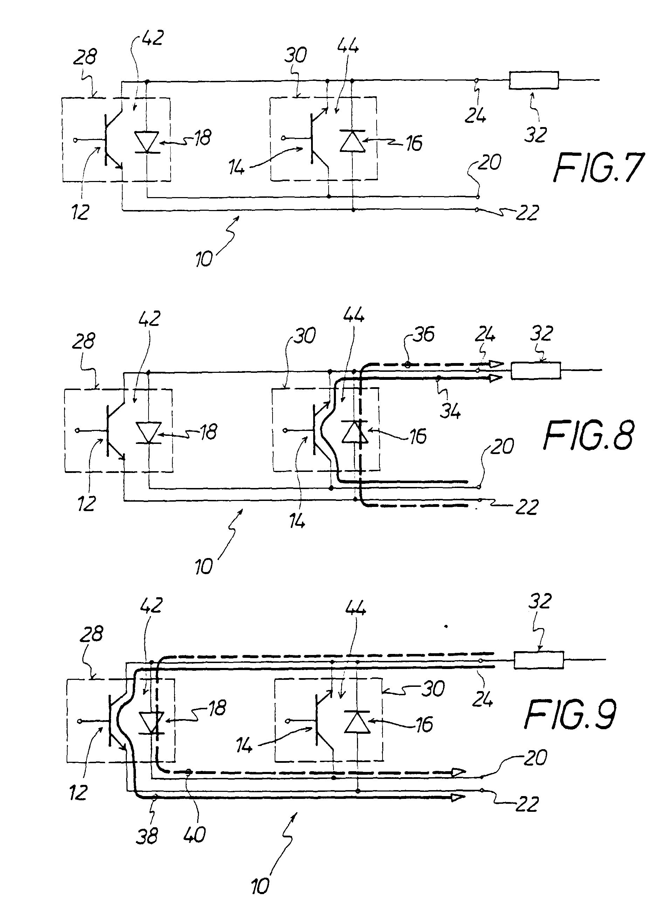

Weitere Einzelheiten ergeben sich aus der nachfolgenden Beschreibung der erfindungsgemässen, in den Figuren 7, 8 und 9 schaltungsmässig verdeutlichten Stromrichterschaltungsanordnung.

Aus Fig. 7 ist ersichtlich, dass das schaltbare Bauelement 12 und die Freilaufdiode 18 bzw. das schaltbare Bauelement 14 und die Freilaufdiode 16 des jeweiligen Kommutierungszweiges 42 bzw. 44 jeweils eng benachbart vorgesehen sind. Hierbei sind in Fig. 7 entsprechend Fig. 4 zwei Subsysteme angedeutet, wobei jedes der beiden Subsysteme von einem der beiden Kommutierungszweige 42, 44 gebildet ist, d.h. das schaltbare Bauelement 12 und die Freilaufdiode 18 des entsprechenden Kommutierungszweiges 42 sind an einem Substrat 28 und das schaltbare Bauelement 14 und die Freilaufdiode 16 des entsprechenden anderen Kommutierungszweiges 44 sind an einem Substrat 30 vorgesehen.

Mit der Bezugsziffer 24 ist auch in den Figuren 7 bis 9, in denen gleiche Einzelheiten jeweils mit denselben Bezugsziffern bezeichnet sind, der Wechselstrom-Lastanschluss bezeichnet, an den eine induktive oder gemischt ohmsch-induktive Last 32 angeschlossen ist. Die Bezugsziffer 20 bezeichnet auch in diesen Figuren den ersten Gleichspannungsanschluss und die Bezugsziffer 22 den zweiten Gleichspannungsanschluss.

Aus den Figuren 7, 8 und 9 ist auch ersichtlich, dass die beiden Gleichspannungsanschlüsse 20 und 22 eng benachbart vorgesehen sind, so dass die Induktivität relativ gering ist. Die beiden Gleichspannungsanschlüsse 20 und 22 können hierbei in vorteilhafter Weise auf der einen Seite der beiden Substrate 28 und 30 vorgesehen sein, während der Wechselspannungs-Lastanschluss 24 vorzugsweise auf der den beiden Gleichspannungsanschlüssen 20 und 22 gegenüberliegenden Seite der beiden Substrate 28 und 30 für die Kommutierungszweige 42 und 44 vorgesehen ist.

Bei den Substraten 28 und 30 kann es sich bspw. um Substrate aus einem elektrisch isolierenden und relativ gut wärmeleitenden Material wie einem keramischen Sintermaterial handeln. Die schaltbaren Bauelemente 12 und 14 bzw. die Freilaufdioden 16 und 18 sind vorzugsweise als Chipbauelemente ausgebildet, die in geeigneter Art und Weise am entsprechenden Substrat 28 bzw. 30 fixiert und miteinander verschaltet sein können.

## Patentansprüche

1. Stromrichterschaltungsanordnung mit zwei zwischen einem ersten und einem zweiten Gleichspannungsanschluss (20, 22) in Reihe hintereinandergeschalteten schaltbaren Bauelementen (12, 14), zwischen welchen sich ein Wechselstrom-Lastanschluss (24) befindet, wobei zu jedem der beiden schaltbaren Bauelemente (12, 14) eine Freilaufdiode (16, 18) antiparallel geschaltet derart zugeordnet ist, dass sich zwei Kommutierungszweige (42, 44) ergeben, von welchen jeder durch das jeweils eine schaltbare Bauelement (12, 14) und die zum jeweils anderen schaltbaren Bauelement (14, 12) antiparallelgeschaltete Freilaufdiode (16, 18) gebildet ist,
**dadurch gekennzeichnet**,
dass das schaltbare Bauelement (12, 14) und die Freilaufdiode (18, 16) des entsprechenden Kommutierungszweiges (42, 44) zueinander benachbart vorgesehen sind, wobei das schaltbare Bauelement (12, 14) und die Freilaufdiode (18, 16) des jeweiligen Kommutierungszweiges (42, 44) jeweils an einem zugehörigen elektrisch isolierenden Substrat (28, 30) vorgesehen und jedem der beiden Substrate (28, 30) für den jeweils zugehörigen Kommutierungszweig (42, 44) die beiden Gleichspannungsanschlüsse (20, 22) und der Wechselstrom-Lastanschluss (24) zugeordnet sind.

2. Stromrichterschaltungsanordnung nach Anspruch 1,
**dadurch gekennzeichnet,**
dass die beiden Gleichspannungsanschlüsse (20, 22) zueinander benachbart vorgesehen sind.

3. Stromrichterschaltungsanordnung nach Anspruch 1 oder 2,
**dadurch gekennzeichnet,**
dass die beiden Gleichspannungsanschlüsse (20, 22) der beiden Kommutierungszweige (42, 44) auf einer Seite der beiden Substrate (28, 30) vorgesehen sind.

4. Stromrichterschaltungsanordnung nach einem der Ansprüche 1 bis 3,
**dadurch gekennzeichnet,**
dass der Wechselstrom-Lastanschluss (24) auf der den beiden Gleichspannungsanschlüssen (20, 22) gegenüberliegenden Seite der beiden Substrate (28, 30) für die zwei Kommutierungszweige (42, 44) vorgesehen ist.

5. Stromrichterschaltungsanordnung nach einem der vorhergehenden Ansprüche,
**dadurch gekennzeichnet,**
dass das schaltbare Bauelement (12, 14) bzw. die Freilaufdiode (18, 16) des entsprechenden Kommutierungszweiges (42, 44) als Chipbauelemente ausgebildet sind, die jeweils auf einem gemeinsamen Substrat (28, 30) vorgesehen sind.

6. Verwendung einer Stromrichterschaltungsanordnung nach einem der Ansprüche 1 bis 5 bei einer Halbbrückenschaltung mit zwei Gleichspannungsanschlüssen (20, 22) und einem Wechselstrom-Lastanschluss (24).

7. Verwendung von zwei Stromrichterschaltungsanordnungen nach einem der Ansprüche 1 bis 5 bei einer Einphasen-Brückenschaltung mit zwei Gleichspannungsanschlüssen (20, 22) und zwei Wechselstrom-Lastanschlüssen (24).

8. Verwendung von drei Stromrichterschaltungsanordnungen nach einem der Ansprüche 1 bis 5 bei einer Dreiphasen-Brückenschaltung mit zwei Gleichspannungsanschlüssen (20, 22) und drei Wechselstrom-Lastanschlüssen (24).

## Claims

1. A converter circuit assembly having two switchable components (12,14) connected in series between a first and a second DC terminal (20,22), an AC load terminal (24) being connected therebetween, wherein a recovery diode (16,18) is allocated to each of said switchable components (12,14) in antiparallel connection in such way that two commutating branches (42,44) result, each of which is formed by the one respective component (12,14) and the recovery diode (16,18) connected antiparallel to the respective other switchable component (14,12),
characterised in that
the switchable component (12,14) and the recovery diode (18,16) of the corresponding commutating branch (42,44) are provided adjacent to one another, wherein the switchable component (12,14) and the recovery diode (18,16) of the respective commutating branch (42,44) are respectively provided at an associated electrically insulating substrate (28,30), and both DC terminals (20,22) and the AC load terminal (24) are allocated to each of the two substrates (28,30) for the respectively associated commutating branch (42,44).

2. The converter circuit assembly according to Claim 1, characterised in that the two DC Terminals (20,22) are provided adjacent to one another.

3. The converter circuit assembly according to claim 1 or 2, characterised in that the two DC terminals (20,22) of the two commutating branches (42,44) are provided on one side of the two substrates (28,30).

4. The converter circuit assembly according to one of claims 1 to 3, characterised in that the AC load terminal (24) for the two commutating branches (42,44) is provided on the side of the two substrates (28,30) which is opposite of the two DC terminals (20,22).

5. The converter circuit assembly according to one of the preceding claims, characterised in that the switchable component (12,14) and/or the recovery diode (18,16) of the corresponding commutating branch (42,44) are formed as chip components that are respectively provided on a common substrate (28,30).

6. Use of a converter circuit assembly according to one of claims 1 to 5 in a half bridge circuit having two DC terminals (20,22) and one AC load terminal (24).

7. Use of two converter circuit assemblies according to one of claims 1 to 5 in a one phase bridge circuit with two DC terminals (20,22) and two AC load terminals (24).

8. Use of three converter circuit assemblies according to one of claims 1 to 5 in a three phase bridge circuit having two DC terminals (20,22) and three AC load terminals (24).

## Revendications

1. Dispositif convertisseur comportant deux composants commutables (12, 14) branchés en série entre une première et une seconde connexions de tension continue (20, 22), composants entre lesquels se trouve une connexion de charge de courant alternatif (24), une diode de roue libre (16, 28) branchée en anti-parallèle étant associée à chacun des deux composants commutables (12, 14) de telle sorte que deux branches de commutation (42, 44) en résultent, dont chacune est formée par l'un des composants commutables respectivement (12, 14) et la diode de roue libre (16, 18) branchée en anti-parallèle avec respectivement l'autre composant commutable (14, 12),
caractérisé par le fait que le composant commutable (12, 14) et la diode de roue libre (18, 16) de la branche de commutation correspondante (42, 44) sont prévus au voisinage l'un de l'autre, le composant commutable (12, 14) et la diode de roue libre (18, 16) de la branche de commutation (42, 44) respective étant prévus sur un substrat isolant électriquement associé (28, 30), et les deux connexions de tension continue (20, 22) et la connexion de charge de courant alternatif (24) étant affectées à chacun des deux substrats (28, 30) pour la branche de commutation (42, 44) respectivement associée.

2. Dispositif convertisseur selon la revendication 1, caractérisé par le fait que les deux connexions de tension continue (20, 22) sont prévues au voisinage l'une de l'autre.

3. Dispositif convertisseur selon la revendication 1 ou 2, caractérisé par le fait que les deux connexions de tension continue (20, 22) des deux branches de commutation (42, 44) sont prévues sur un côté des deux substrats (28, 30).

4. Dispositif convertisseur selon l'une des revendications 1 à 3, caractérisé par le fait que la connexion de charge de courant alternatif (24) est prévue sur le côté des deux substrats (28, 30) opposé aux deux connexions de tension continue (20, 22) pour les deux branches de commutation (42, 44).

5. Dispositif convertisseur selon l'une des revendications précédentes, caractérisé par le fait que le composant commutable (12, 14) ou la diode de roue libre (18, 16) de la branche de commutation correspondante (42, 44) sont réalisés en tant que composants sous forme de puces, qui sont prévus respectivement sur un substrat commun (28, 30).

6. Utilisation d'un dispositif convertisseur selon l'une des revendications 1 à 5 dans un demi-circuit de pont avec deux connexions de tension continue (20, 22) et une connexion de charge de courant alternatif (24).

7. Utilisation de deux circuits convertisseurs selon l'une des revendications 1 à 5 dans un circuit en pont monophasé avec deux connexions de tension continue (20, 22) et deux connexions de charge de courant alternatif (24).

8. Utilisation de trois dispositifs convertisseurs selon l'une des revendications 1 à 5 dans un circuit en pont triphasé avec deux connexions de tension continue (20, 22) et trois connexions de charge de courant alternatif (24).
